# EUROPEAN PATENT APPLICATION

(11) **EP 4 597 544 A1**
(43) Date of publication of application: **06.08.2025**
(21) Application number: 23872700.2
(22) Date of filing: 19.06.2023
(51) Int. Cl.: H01L 21/02, H01L 21/28

(54) **THIN FILM FORMING METHOD EMPLOYING INTERFACE-NITRIDING TECHNIQUE USING HIGH-DENSITY RADICALS**

(30) Priority: 29.09.2022 KR 20220124369
(71) Applicant: EQ Tech Plus Co., Ltd., Suwon-si, Gyeonggi-do 16648 (KR)
(72) Inventor: SHIN, Dong Hwa, Suwon-si Gyeonggi-do 16648 (KR); KIM, Yong Weon, Suwon-si Gyeonggi-do 16648 (KR)
(74) Representative: Jung, Minkyu
(86) International application number: PCT/KR2023/008426
(87) International publication number: WO 2024/071573

(57) **Abstract**

A method for forming an oxide film by using a deposition apparatus, according to an embodiment of the present disclosure, comprises the steps of: (a) depositing a first thin film composed of a nitride film on a substrate; (b) spraying OH radicals onto the first thin film to oxidize the first thin film, thereby forming an oxynitride film in the first thin film; and (c) forming an insulating film on the first thin film, wherein steps (a) and (b) are selectively repeated to adjust any one of the thickness of the first thin film or the concentration of N inside the first thin film.

## Description

### [Technical Field]

The present disclosure relates to a thin film forming method, and more particularly, to a thin film forming method for nitriding an interface using high-density radicals.

### [Background Art]

As technology advances, semiconductors, which are core technologies of the Fourth Industrial Revolution, such as artificial intelligence, big data, fifth generation (5G), and autonomous vehicles, require a multilayer structure and a complex-shaped circuit pattern to improve the speed of a non-memory device (or a large scale integration (LSI) system) and increase the capacity of a memory (e.g., dynamic random access memory (DRAM) or three-dimensional vertical NAND (3D_VNAND)).

Accordingly, semiconductor patterning technology achieving a line width of 5 nm or less has been secured through the introduction of technology such as extreme ultraviolet (EUV) lithography. However, it is necessary to resolve the limitations of conventional thin film deposition technology, such as nonuniformity of thin film thickness, poor deposition of high aspect ratio contact holes, and low step coverage.

Here, in order to solve the above-mentioned problem, the conventional thin film forming technology reduces defects occurring at an interface by forming an oxide film by oxidizing the substrate or depositing the oxide film on the substrate and then treating the oxide film by using nitrous oxide (N₂O) or nitric oxide (NO) to allow nitrogen (N) to penetrate into the interface. This technology results in enhanced interface characteristics and reliability.

However, the conventional technology also has problems such as environmental issues due to toxic gases, difficulty in adjusting a nitrogen (N) concentration in a nitride film, and deterioration of electrical characteristics occurring due to increased interface roughness as high-temperature processing is performed.

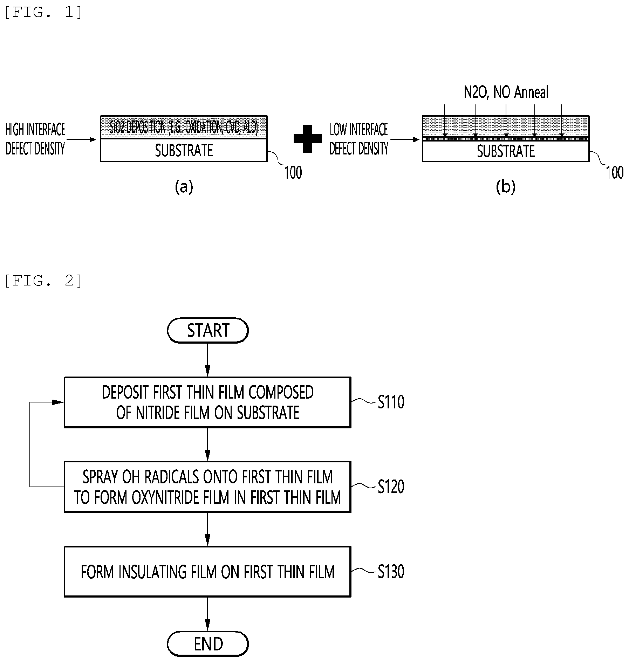

FIG. 1 is an exemplary view showing a conventional interface-nitriding process.

Conventional interface nitriding technology employs a method of forming an oxide film by oxidizing a substrate 100 or depositing the oxide film on the substrate 100, and then performing heat treatment thereon using a gas containing nitrogen (N).

In detail, the conventional technology may form the oxide film by oxidizing the substrate 100 or depositing the oxide film on the substrate 100 and perform annealing thereon by using the gas containing N (e.g., nitrogen dioxide (N₂O) or nitrogen oxide

(NO)) as shown in FIGS. 1 of (a) and (b), respectively. Here, if the annealing is performed excessively to increase an N concentration, the N concentration in an interface between the substrate 100 and silicon dioxide (SiO₂) as well as in SiO₂ itself may be increased, which may deteriorate the characteristics of a semiconductor device.

Meanwhile, when only the oxide film is formed as shown in FIG. 1 of (a), interface defects may occur due to incomplete bonding such as dangling bonds at the interface between SiO₂ and the substrate 100, which results in a high interface defect density. However, when the annealing is performed using the gas containing N as shown in FIG. 1 of (b), the interface defects such as the incomplete bonding at the interface between SiO₂ and the substrate 100 and the dangling bond may be reduced. Here, in addition to N, oxygen (O) or hydrogen (H) may also be used based on a process or a material.

In addition, the conventional technology breaks atomic bonds in SiO₂ to form SiON, which requires significant energy to break the bonds between atoms. Therefore, a conventional post-processing process may use a heat treatment method or a plasma treatment method at a high temperature of 900°C or higher to break the atomic bonds.

Here, the plasma method may use excessively high energy, and have a negative effect on the durability of a semiconductor product or the durability of deposition equipment itself. In addition, the conventional heat treatment method may perform the process at an excessively high temperature and thus also have a similar disadvantage. In general, the plasma method may use higher energy than the heat treatment method. Accordingly, the plasma method may be used when desired thin film deposition is not performed using the heat treatment method.

In addition, the conventional technology has the following problems: when the molecules converted to silicon oxynitride (SiON) by reacting with N through breaking the atomic bonds in SiO₂ reach a predetermined concentration or higher, a reaction with N may not occur and injection using the higher energy may be required. Here, the N concentration may be increased in SiO₂ itself rather than at the interface between SiO₂ and the substrate, thus making it difficult to improve device characteristics due to limitations in adjusting the N concentration and SiON thickness.

### [Disclosure]

### [Technical Problem]

An object of the present disclosure is to reduce interface defects and enhance thin film characteristics by improving imperfect bonding at an interface between a substrate and a silicon nitride (SiN) thin film, which is oxidized by high-density radicals.

In addition, it is generally difficult to oxidize SiN because SiN has high-energy bonds. However, another object of the present disclosure is to adjust a nitrogen (N) concentration and a thickness of silicon oxynitride (SiON) through radical density control by oxidation at a low temperature (e.g., 480 to 730°C) and regulation of a gas flow rate, and through SiN oxidation by controlling the exposure time and amount of high-density radicals.

However, aspects of the present disclosure are not limited to the above-mentioned aspects, and the present disclosure may also include other aspects.

### [Technical Solution]

In one general aspect, provided is a method for forming an oxide film by using a deposition apparatus, the method including steps of: a) depositing a first thin film composed of a nitride film on a substrate; (b) spraying hydroxyl (OH) radicals onto the first thin film to oxidize the first thin film, thereby forming an oxynitride film in the first thin film; and (c) forming an insulating film on the first thin film, wherein steps (a) and (b) are selectively repeated to adjust any one of a thickness of the first thin film or a nitrogen (N) concentration in the first thin film.

In step (a), the first thin film may be deposited using either a chemical vapor deposition (CVD) technology or an atomic layer deposition (ALD) technology.

The first thin film may be composed of silicon nitride (SiN), and the oxynitride film may be composed of silicon oxynitride (SiON).

SiN may react with the OH radicals to form SiON in step (b) if the first thin film is composed of SiN.

A concentration of the SiON component in a lower part of the oxynitride film may be lower than that in an upper part of the oxynitride film.

The process of spraying the OH radicals in step (b) may be performed at a process temperature of 480 to 730°C.

Steps (a) to (c) may be included in a process of forming a gate oxide film during a process of forming a semiconductor device.

### [Advantageous Effects]

According to an embodiment of the present disclosure, the interface defects may be reduced and the thin film characteristics may be enhanced by improving the imperfect bonding at the interface between the substrate and the silicon nitride (SiN) thin film, which is oxidized by the high-density radicals.

In addition, it is generally difficult to oxidize SiN because SiN has the high-energy bonds. However, according to an embodiment of the present disclosure, the nitrogen (N) concentration and the thickness of silicon oxynitride (SiON) may be adjusted through the radical density control by the low-temperature oxidation (480 to 730°C) and the regulation of the gas flow rate, and through the SiN oxidation by controlling the exposure time and amount of the high-density radicals.

After SiN is deposited through this process, the subsequent heat treatment may be performed by injecting hydroxyl (OH) radicals onto the interface, or SiON may be formed at the interface using the atomic layer deposition (ALD) technology.

### [Description of Drawings]

FIG. 1 is an exemplary view showing a conventional interface-nitriding process.
FIG. 2 is an operational flowchart showing a thin film forming process in which an interface-nitriding technique is employed using high-concentration radicals according to an embodiment of the present disclosure.
FIGS. 3A to 3D are views showing a shape of a thin film corresponding to each step of forming the thin film according to an embodiment of the present disclosure.

### [Best Mode]

Hereinafter, embodiments of the present disclosure are described in detail with reference to the accompanying drawings so that those skilled in the art to which the present disclosure pertains may easily practice the present disclosure. However, the present disclosure may be modified in various different forms, and is not limited to the embodiments provided herein. In addition, in the drawings, portions unrelated to the description are omitted to clearly describe the present disclosure, and similar portions are denoted by similar reference numerals throughout the specification.

Throughout the present specification, when any part is referred to as being "connected to" another part, it indicates that any part and another part are "directly connected to" each other or are "electrically connected to" each other while having yet another part interposed therebetween. In addition, unless explicitly stated otherwise, any part "including" any components indicates the inclusion of other components rather than the exclusion of other components.

The following embodiments are detailed descriptions to assist in the understanding of the present disclosure and do not limit the scope of the present disclosure. Therefore, inventions of the same scope that perform the same function as the present disclosure also fall within the scope of the present disclosure.

A thin film or deposition, as defined in the specification of the present disclosure below, may indicate a process of thinly coating an oxide or metal by alternately adsorbing and substituting molecules on a surface of a wafer (substrate) in a semiconductor manufacturing process. Accordingly, each process described in the following specification may be performed by a radical unit, a deposition device, or the like, and the thin film or the deposition may be implemented through technology such as atomic layer deposition (ALD) or chemical vapor deposition (CVD).

FIG. 2 is a process flowchart showing a process of forming an oxide film that is capable of solving the problems of a conventional deposition technology and effectively adjusting a nitrogen (N) concentration according to an embodiment of the present disclosure.

Referring to FIG. 2, a first thin film 110 composed of a nitride film may be deposited on a substrate 100 by using a deposition apparatus (S110).

Here, the deposition apparatus is an apparatus that performs either a chemical vapor deposition (CVD) technology or an atomic layer deposition (ALD) technology, and may perform the deposition of the first thin film 110 by using the corresponding technology.

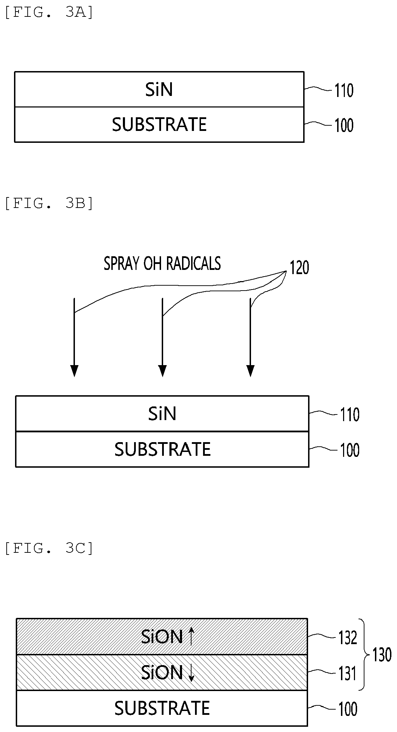

Here, according to a selective embodiment, as shown in FIG. 3A, the first thin film 110 initially deposited on the substrate 100 may be composed of silicon nitride (SiN), and an oxynitride film 130 described below may be composed of silicon oxynitride (SiON).

Next, as shown in FIG. 3B, the hydroxyl (OH) radicals 120 may be sprayed onto the first thin film 110 to form the oxynitride film 130 in the first thin film 110 (S120).

SiN may react with the OH radicals 120 to form SiON in step S120 if the first thin film 110 is composed of SiN in step S110 as in FIG. 3B.

In detail, in the present disclosure, the OH radicals 120 may be sprayed onto SiN at a high concentration, and the OH radicals 120 may penetrate into the thin film. Here, after the OH radicals 120 penetrate into the thin film, SiN and OH may react with each other to form a new compound referred to as silicon monoxide (SiO) or SiON, rather than reacting with each other by breaking atomic bonds in SiN. Accordingly, in the above process, SiO or SiON may be formed even at a relatively low temperature of 480 to 730°C, unlike a conventional high-temperature heat treatment.

Here, as shown in FIG. 3C, the oxynitride film 130 may have a concentration of the SiON component in a lower part 131 of the oxynitride film 130 lower than that in an upper part 132 of the oxynitride film 130. The reason is that SiON is formed as the OH radicals penetrate into SiON and react with the same, thus making the SiON concentrations in the upper part 132 and the lower part 131 of the oxynitride film 130 different from each other. Meanwhile, in addition to SiON, the SiO component may also remain in the oxynitride film 130, and the SiO component in the lower part 131 of the oxynitride film 130 may have a concentration higher than that in the upper part 132.

In addition, the process of spraying the OH radicals 120 in step S120 may be performed at a process temperature of 480 to 730°C. The process may be performed at such a low temperature, and does not have a significant effect on the durability of the substrate, the thin film, or other equipment.

Meanwhile, steps S110 and S120 may be selectively repeated to adjust any one of a thickness of the first thin film 110 or a nitrogen (N) concentration in the first thin film 110. In addition, if a SiN thickness is formed to be thick and a concentration of the OH radicals 120 is adjusted, either a SiO concentration or a SiON concentration in the thin film may be adjusted. In general, SiN may not be oxidized to SiON simply by heat. However, its oxidation may be induced even at the low temperature by using the OH radicals 120.

If this process is performed repeatedly, SiON having a desired thickness may be formed, thus enabling adjustment to the desired N concentration. Here, generally, the N concentration in an interface layer between silicon dioxide (SiO₂) 140 and the substrate 100 is required to satisfy a predetermined level or higher. However, the process according to the present disclosure may precisely control the N concentration in the interface layer to the predetermined level, and apply N only to a desired interface layer while not applying N at all to SiO₂ 140.

Finally, an insulating film may be formed on the first thin film 110 (S130).

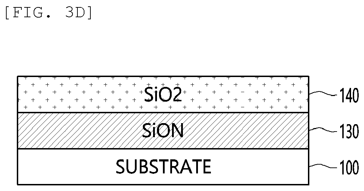

In this way, the insulating film composed of SiO₂ 140 may be formed on the oxynitride film 130 composed of SiON as shown in FIG. 3D, thereby completing a thin film forming process.

Here, steps S110 to S130 may be included in a process of forming a gate oxide film during a process of forming a semiconductor device.

Therefore, the incomplete bonding at the interface between the substrate 100 and the SiN thin film, which is oxidized by the high-density radicals, may be improved through the process disclosed above, thereby reducing the interface defects and enhancing the thin film characteristics of the conventional process. In addition, it is difficult to oxidize SiN through the conventional process because SiN has high-energy bonds. However, through the process according to the present disclosure, the N concentration and the SiON thickness may be adjusted through the radical density control by the oxidation at the low temperature and the regulation of the gas flow rate, and through the SiN oxidation by controlling the exposure time and amount of the high-density radicals. In addition, after SiN is deposited through the process according to the present disclosure, the subsequent heat treatment may be performed by injecting the OH radicals onto the interface, or SiON may be formed at the interface using the ALD technology.

The above-described embodiments are illustratively provided, and it is apparent to those skilled in the art to which the present disclosure pertains that the present disclosure may be embodied in another specific form without any change in its technical idea or essential characteristics. Therefore, it should be understood that the embodiments described hereinabove are illustrative rather than restrictive in all aspects. For example, the components each described as a single type may also be implemented in a distributed manner, and similarly, the components described as being distributed from each other may also be implemented in a coupling manner.

It should be understood that the scope of the present disclosure is defined by the claims disclosed below rather than the detailed description provided above, and includes all alternations and modifications derived from the claims and their equivalents.

## Claims

1. A method for forming an oxide film by using a deposition apparatus, the method comprising steps of:
(a) depositing a first thin film composed of a nitride film on a substrate;
(b) spraying OH radicals onto the first thin film to oxidize the first thin film, thereby forming an oxynitride film in the first thin film; and
(c) forming an insulating film on the first thin film,
wherein steps (a) and (b) are selectively repeated to adjust any one of a thickness of the first thin film or a nitrogen (N) concentration in the first thin film.

2. The method of claim 1, wherein in step (a), the first thin film is deposited using either a chemical vapor deposition (CVD) technology or an atomic layer deposition (ALD) technology.

3. The method of claim 1, wherein the first thin film is composed of silicon nitride (SiN), and the oxynitride film is composed of silicon oxynitride (SiON).

4. The method of claim 1, wherein SiN reacts with the OH radicals to form SiON in step (b) if the first thin film is composed of SiN.

5. The method of claim 1, wherein a concentration of the SiON component in a lower part of the oxynitride film is lower than that in an upper part of the oxynitride film.

6. The method of claim 1, wherein the process of spraying the OH radicals in step (b) is performed at a process temperature of 480 to 730°C.

7. The method of claim 6, wherein steps (a) to (c) are included in a process of forming a gate oxide film during a process of forming a semiconductor device.
